# EUROPEAN PATENT SPECIFICATION

(11) **EP 2 852 978 B1**
(45) Date of publication and mention of the grant of the patent: **27.02.2019**
(21) Application number: 13793235.6
(22) Date of filing: 09.05.2013
(51) Int. Cl.: H01L 29/778, H01L 21/336, H01L 29/423, H01L 29/20, H01L 21/311

(54) **HEMT DEVICE AND METHOD OF MANUFACTURING THE SAME**
HEMT-VORRICHTUNG UND VERFAHREN ZUR HERSTELLUNG DAVON
DISPOSITIF TRANSISTOR À EFFET DE CHAMP À HAUTE MOBILITÉ ÉLECTRONIQUE (HEMT) ET PROCÉDÉ DE FABRICATION ASSOCIÉ

(30) Priority: 23.05.2012 US 201213478609; 23.05.2012 US 201213479018; 23.05.2012 US 201213478402
(43) Date of publication of application: 01.04.2015
(73) Proprietor: HRL Laboratories, LLC, Malibu, CA 90265-4799 (US)
(72) Inventor: KHALIL, Sameh, Encino, CA 91316-2166 (US); BOUTROS, Karim, S., Moorpark, CA 93021 (US); SHINOHARA, Keisuke, Thousand Oaks, CA 91360 (US)
(74) Representative: Farrington, Graham
(86) International application number: PCT/US2013/040431
(87) International publication number: WO 2013/176904

(56) References cited:
- KR-A- 20110 136 719
- US-A1- 2004 144 991
- US-A1- 2006 220 065
- US-A1- 2009 072 272
- US-A1- 2010 219 452
- US-A1- 2012 098 599
- SABA RAJABI ET AL: "A novel power High Electron Mobility Transistor with partial stepped recess in the drain access region for performance improvement", SIGNAL PROCESSING, COMMUNICATION, COMPUTING AND NETWORKING TECHNOLOGIES (ICSCCN), 2011 INTERNATIONAL CONFERENCE ON, IEEE, 21 July 2011 (2011-07-21), pages 269-271, XP031940754, DOI: 10.1109/ICSCCN.2011.6024557 ISBN: 978-1-61284-654-5

## Description

### TECHNICAL FIELD

This disclosure presents a high electron mobility transistor (HEMT) GaN device with a non-uniform lateral two dimensional electron gas profile and a method of manufacturing the same. This disclosure relates to type III - nitride high electron mobility transistor (HEMT) devices and in particular to two dimensional electron gas (2DEG) in the drift region.

### BACKGROUND

A high electron mobility transistor (HEMT) is a field effect transistor incorporating a junction between two materials with different band gaps (i.e., a heterojunction). Gallium nitride (GaN) HEMTs have attracted attention due to their high-power performance. In type III-nitride HEMT devices used in power applications there is a conflicting design trade-off between the on-state resistance and breakdown voltage (BV). Since the relation between the BV and on resistance is at least quadratic, improvement in the BV for a given drift region length results in a significant improvement in the FOM of the device, defined as BV²/Ron.

In the prior art type III-nitride HEMT devices have a uniform 2DEG density which results in a peak electric field under or near the gate region. The electric field distribution tends to be closer to a triangular shape than to the desired trapezoidal shape which reduces the breakdown voltage per unit drift region length of the device. The use of field plate and multistep field plates are some of the techniques that are used to improve the electric field distribution. However, field plates typically result in multiple peaks and suffer from less than an ideal flat field distribution, and may exhibit a saw tooth profile. Field plates also add to the gate to drain capacitance. In addition, process complexity and cost typically increase with the number of field plate steps.

U.S. Patent No. 7,038,253 to Furukawa describes a GaN based device on silicon (Si) technology which uses a uniform 2DEG profile in the drift region. Because of the absence of any field shaping technique in the Furukawa device, the breakdown voltage and dynamic on resistance from drain to source is limited by a localized increase in the electric field under the gate region thus requiring over design of the device which degrades the figure of merit (FOM) that such a device can achieve.

In "High Breakdown Voltage AlGaN/GaN HEMTs Achieved by Multiple Field Plates" by H. Xing et. Al, a field shaping technique that uses multiple field plates is described to improve the electric field distribution. However, multiple field plates do not achieve a uniform electric field, may have a saw tooth type distribution, and introduce gate to drain capacitance. Implementing such a device structure also increases device complexity and cost.

What is needed is a significant improvement in the FOM in HEMT devices, and in particular an improvement in the breakdown voltage for a given drift region length, so that the FOM of the device, defined as BV²/Ron, improves. The embodiments of the present disclosure answer these and other needs.

US2004144991 discloses a compound semiconductor device that comprises an i-GaN buffer layer 12 formed on an SiC substrate 10; an n-AlGaN electron supplying layer 16 formed on the i-GaN buffer layer 12; an n-GaN cap layer 18 formed on the n-AlGaN electron supplying layer 16; a source electrode 20 and a drain electrode 22 formed on the n-GaN cap layer 18; a gate electrode 26 formed on the n-GaN cap layer 18 between the source electrode 20 and the drain electrode 22; a first protection layer 24 formed on the n-GaN cap layer 18 between the source electrode 20 and the drain electrode 22; and a second protection layer 30 buried in an opening 28 formed in the first protection layer 24 between the gate electrode 26 and the drain electrode 22 down to the n-GaN cap layer 18 and formed of an insulation film different from the first protection layer.

The paper *"*A novel power High Electron Mobility Transistor with partial stepped recess in the drain access region for performance improvement" by Saba Rajabi; Ali A. Orouji; Hamid Amini Moghadam; and S. E. Jamali Mahabadi; International Conference on Signal Processing, Communication, Computing and Networking Technologies (ICSCCN), 2011, IEEE 21-22 July 2011, pages 269-271, discloses a new power High Electron Mobility Transistor (HEMT) with partial stepped recess in the drain access region. This approach represents a new way to increase the breakdown voltage by 100%, which is very important in higher voltage applications. The use of drain access region recesses allows a 43% decrease of the peak electric field and only a 1.91% increase of the drain access resistance which is negligible. The proposed structure shows an improvement in the maximum oscillation frequency (fmax) and cut-off frequency (fT) over the conventional structure.

### SUMMARY

In a first embodiment disclosed herein, a high electron mobility field effect transistor (HEMT) having a substrate, a channel layer on the substrate and a barrier layer on the channel layer comprises a stress inducing layer on the barrier layer, the stress inducing layer varying the piezo-electric effect in the barrier layer in a drift region between a gate and a drain, wherein a two dimensional electron gas (2DEG) has a non-uniform lateral distribution in the drift region between the gate and the drain.

In yet another embodiment disclosed herein, a method of fabricating a high electron mobility field effect transistor (HEMT) comprises forming a channel layer on a substrate, forming a barrier layer on the channel layer, and forming a stress inducing layer on the barrier layer, the stress inducing layer varying the piezo-electric effect in the barrier layer in a drift region between a gate and a drain, wherein a two dimensional electron gas (2DEG) has a non-uniform lateral distribution in the drift region between the gate and the drain.

These and other features and advantages will become further apparent from the detailed description and accompanying figures that follow. In the figures and description, numerals indicate the various features, like numerals referring to like features throughout both the drawings and the description.

### BRIEF DESCRIPTION OF THE DRAWINGS

FIG. 1 shows a deposited layer on top of the carrier supplying layer with varying size openings to induce a stress and modulate the density of a two dimensional electron gas (2DEG) in a HEMT device in accordance with the present disclosure;
FIG. 2 shows a deposited layer on top of the carrier supplying layer with a varying height profile to induce a stress and modulate the density of a two dimensional electron gas (2DEG) in a HEMT device that does not form part the claimed invention; and
FIGs. 3A and 3B are flow diagrams for methods of fabricating a HEMT device in accordance with the present disclosure.

### DETAILED DESCRIPTION

In the following description, numerous specific details are set forth to clearly describe various specific embodiments disclosed herein. One skilled in the art, however, will understand that the presently claimed invention may be practiced without all of the specific details discussed below. In other instances, well known features have not been described so as not to obscure the invention.

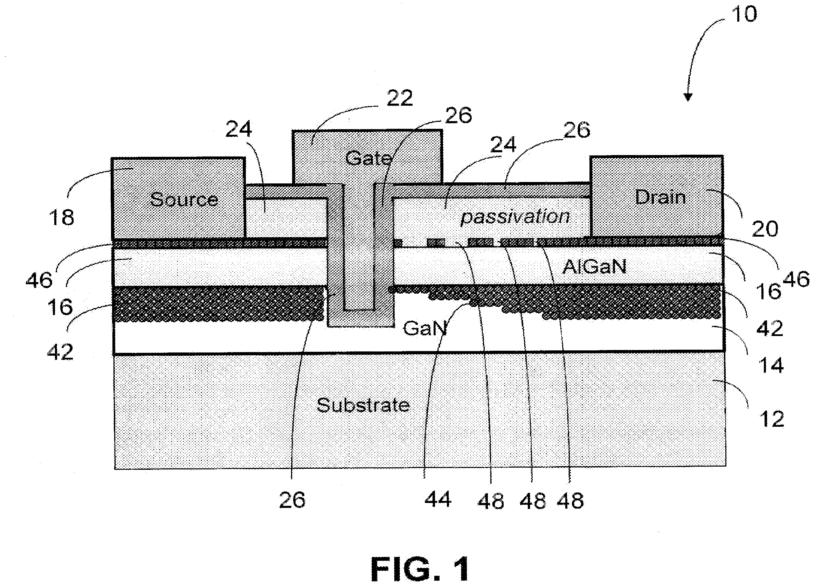

Referring now to FIG. 1, a field effect transistor (FET) device structure 10 is shown. The FET device structure 10 is composed of a stack of III-V layers, such as GaN layer 14 and AlGaN layer 16, grown on a substrate 12 that can be any of the suitable substrates that are commonly used to grow type III-Nitride materials. Suitable substrates include but are not limited to silicon (Si), Sapphire, silicon carbide (SiC), and bulk single crystal gallium nitride (GaN).

The stack of III-V layers may include a buffer layer of GaN or aluminum gallium nitride (AlGaN) grown on the substrate 12. Then a type III layer, such as GaN layer 14, for the channel and carrier travelling layer, is grown on the buffer layer. Then a type V layer, such as AlGaN layer 16, for the barrier layer and the carrier supplying layer, is grown on top of the GaN layer 14. An AlN spacer layer may be between the GaN layer 14 and the AlGaN layer 16 to improve device electrical performance.

As shown in FIG. 1, on top of the barrier layer layer 16 a stress inducing layer 46 is grown to induce a stress and modulate the charge in the 2DEG 42, as shown in FIG. 1. In one embodiment the stress inducing layer 46 is etched with openings 48 in specific areas, as shown in FIG. 1, using a mask. The stress inducing layer 46 modulates the stress in the stress inducing layer 46. The stress varies the piezoelectric effect in the barrier layer 16 and hence the 2DEG 42 in a drift region between the gate 22 and the drain 20.

The lateral control of the stress in the stress inducing layer 46 over the drift region may be achieved by etching different size openings 48 in the stress inducing layer 46 that either increase or decrease in size from the gate 22 to the drain 20 depending on the polarity of the stress the deposited layer is exerting on the barrier or charge supplying layer.

If it is desired to increase the piezoelectric effect in the drift region from gate 22 to drain 20, the size of the openings 48 are larger near the gate 22 and decrease in size towards the drain 20, as shown in FIG. 1.

If it is desired to reduce the piezoelectric effect in the drift region from the gate 22 to the drain 20, the size of the openings 48 are made smaller near the gate 22 and increase in size towards the drain 20.

Since the density of charge in the 2DEG region is determined locally by the magnitude of the piezoelectric effect, a non-uniform 2DEG 42 distribution may be achieved by varying the magnitude of piezoelectric effect over the drift region as a function of distance from the gate 22 towards the drain 20 along the drift region. In the embodiment shown in FIG. 1 the piezoelectric effect in the drift region increases from the gate 22 towards the drain 20, and the size of the openings 48 are larger near the gate 22 and decrease in size towards the drain 20. Such an embodiment results in the 2DEG 42 varying in density such that the 2DEG increases in density in the drift region from the gate 22 towards the drain 20.

As described above, if it is desired to reduce the piezoelectric effect in the drift region from gate 22 to drain 20, the size of the openings 48 may be made smaller near the gate 22 and increased in size towards the drain 20.

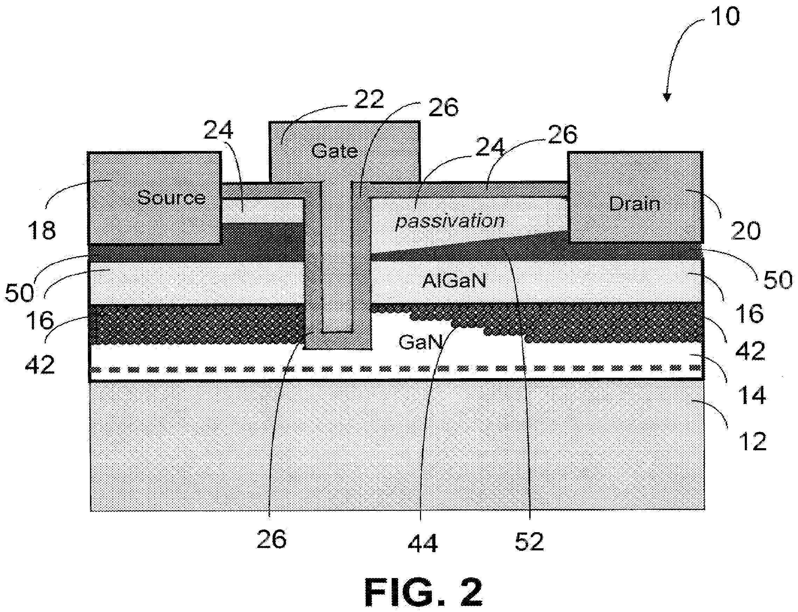

In another embodiment, shown in FIG. 2, which does not form part of the claimed invention, a stress inducing layer 50 is grown on top of the AlGaN layer 16. The non-uniform lateral 2DEG 44 is achieved in this embodiment by using Gray scale photolithography to form a stress inducing layer 50 having a lateral profile that has a height that varies.

Gray scale photolithography uses a gray scale mask to form a stress inducing layer 50 that has a lateral profile and has a height that increases or decreases in the drift region between the gate 22 and the drain 20, depending on the polarity of the stress to be induced.

In the embodiment shown in FIG. 2, the height of the stress inducing layer 50 increases in the drift region between the gate 22 and the drain 20. The stress inducing layer 50 varies the magnitude of piezoelectric effect over the drift region as a function of distance from the gate 22 towards the drain 20 along the drift region. In the embodiment shown in FIG. 2, the stress and the piezoelectric effect in the drift region increases from the gate 22 towards the drain 20. Such an embodiment results in the 2DEG 42 varying in density such that the 2DEG 44 increases in density in the drift region from the gate 22 towards the drain 20.

As described above, if it is desired to reduce the piezoelectric effect in the drift region from the gate 22 to the drain 20, the height of the stress reducing layer 50 decreases in the drift region in the direction from the gate 22 towards the drain 20.

The source contact 18 and the drain contact 20 are formed by metal evaporation or metal sputtering to contact the barrier layer 16 after opening a contact window in the stress inducing layer 46, in the embodiment of FIG. 1, or stress inducing layer 50, in the embodiment of FIG. 2.

A passivation layer 24 may be grown on top of the stress inducing layer 46 or the stress inducing layer 50.

A gate region is then formed by etching a trench through the passivation layer 24 and the stress inducing layer 46 or 50 in a gate area between the source 18 and drain 20 and into the AlGaN layer 16. In another embodiment the etched trench may extend through the AlGaN layer 16 and partially into the GaN layer 14 to an appropriate depth. A gate dielectric 26 is then deposited over the area between the source 18 and gate 22 and the gate 22 and the drain 20, and also deposited to line the etched trench that extends into the AlGaN layer 16. If the etched trench extends into the GaN layer 14, then the gate dielectric 26 also lines the etched trench that extends into the GaN layer 14.

After deposition of the gate dielectric 26, gate metal 22 is formed by evaporation or sputtering and fills the etched trench.

Various alternating passivation and metallization layers may be formed as a part of back-end processing to improve the parasitic resistance of the device and provide connection to device pads and/or a package.

Use of the stress inducing layer 46 or 50 to vary the piezo-electric effect in the barrier or charge supplying layer 16, and hence the 2DEG density in the drift region between the gate 22 and the drain 20, may provide a significant improvement of the figure of merit (FOM) in type III Nitride HEMT devices by achieving a flat electric field distribution in the drift region between the gate 22 and the drain 20. The 2DEG 42 is varied in the drift region to form a non-uniform lateral 2DEG distribution 44, as shown in FIGs. 1 and 2. A flat electric field distribution results from the non-uniform lateral 2DEG distribution 44 along the drift region which provides the improvement in the figure of merit (FOM), defined as BV²/Ron.

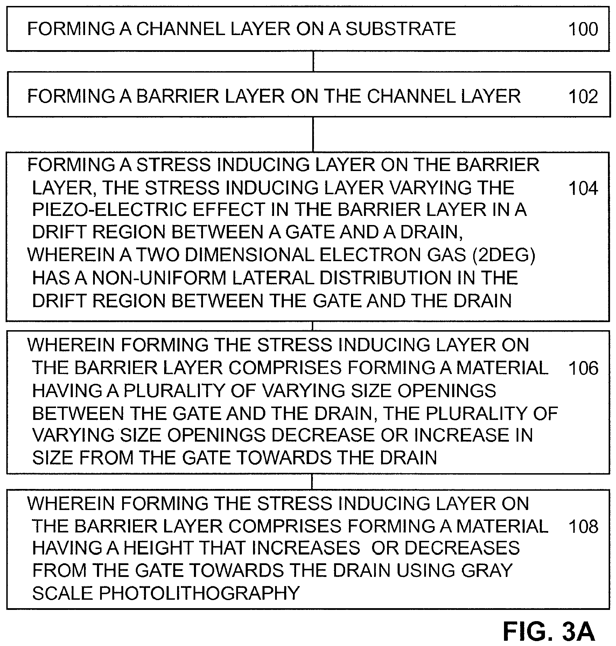

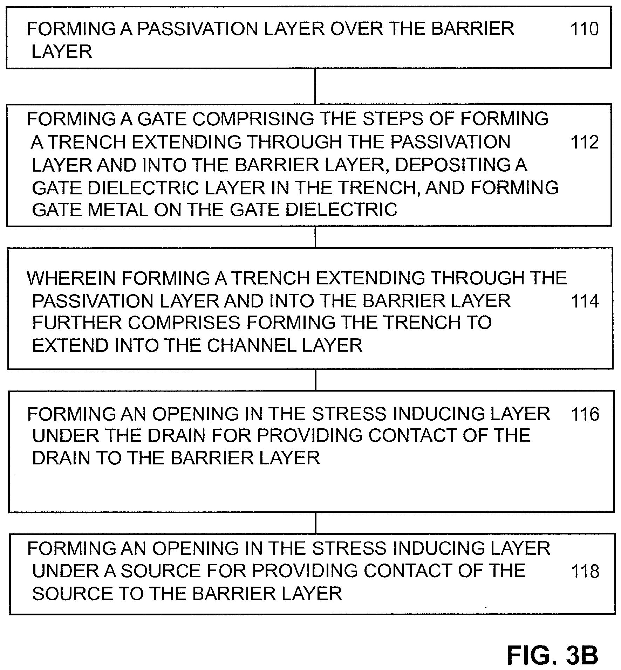

FIGs. 3A and 3B are flow diagrams for methods of fabricating a HEMT device in accordance with the present disclosure.

In step 100 a channel layer is formed on a substrate. Then in step 102 a barrier layer is formed on the channel layer. Next in step 104 a stress inducing layer is formed on the barrier layer, the stress inducing layer varying the piezo-electric effect in the barrier layer in a drift region between a gate and a drain, wherein a two dimensional electron gas (2deg) has a non-uniform lateral distribution in the drift region between the gate and the drain.

In step 106 forming the stress inducing layer on the barrier layer includes forming a material having a plurality of varying size openings between the gate and the drain, the plurality of varying size openings decrease or increase in size from the gate towards the drain.

In step 108, in a method which does not form part of the claimed invention, forming the stress inducing layer on the barrier layer includes forming a material having a height that increases or decreases from the gate towards the drain using gray scale photolithography.

In step 110 a passivation layer is formed over the barrier layer. In step 112 a gate is formed comprising the steps of forming a trench extending through the passivation layer and into the barrier layer, depositing a gate dielectric layer in the trench, and forming gate metal on the gate dielectric. In step 114 the forming a trench extending through the passivation layer and into the barrier layer further includes forming the trench to extend into the channel layer.

In step 116 an opening is formed in the stress inducing layer under the drain for providing contact of the drain to the barrier layer. And finally, in step 118 an opening is formed in the stress inducing layer under a source for providing contact of the source to the barrier layer

Having now described the invention in accordance with the requirements of the patent statutes, those skilled in this art will understand how to make changes and modifications to the present invention to meet their specific requirements or conditions.

The foregoing Detailed Description of exemplary and preferred embodiments is presented for purposes of illustration and disclosure in accordance with the requirements of the law. It is not intended to be exhaustive nor to limit the invention to the precise form(s) described, but only to enable others skilled in the art to understand how the invention may be suited for a particular use or implementation. The possibility of modifications and variations will be apparent to practitioners skilled in the art. No limitation is intended by the description of exemplary embodiments which may have included tolerances, feature dimensions, specific operating conditions, engineering specifications, or the like, and which may vary between implementations or with changes to the state of the art, and no limitation should be implied therefrom. Applicant has made this disclosure with respect to the current state of the art, but also contemplates advancements and that adaptations in the future may take into consideration of those advancements, namely in accordance with the then current state of the art. It is intended that the scope of the invention be defined by the Claims as written Reference to a claim element in the singular is not intended to mean "one and only one" unless explicitly so stated. Moreover, no element, component, nor method or process step in this disclosure is intended to be dedicated to the public regardless of whether the element, component, or step is explicitly recited in the Claims.

## Claims

1. A high electron mobility field effect transistor (10) having a substrate (12), a channel layer (14) on the substrate and a barrier layer (16) on the channel layer (14), the high electron mobility field effect transistor (10) being **characterized in that** it comprises:
a stress inducing layer (46) on the barrier layer (16), the stress inducing layer (46) comprising a material having a plurality of varying size openings (48) in a drift region between a gate (22, 26) and a drain (20) such that the stress inducing layer (46) modulates the piezo-electric effect in the barrier layer (16) along the drift region;
such that a two dimensional electron gas (44) has a non-uniform lateral distribution in the drift region.

2. The high electron mobility field effect transistor (10) of claim 1:
wherein the plurality of varying size openings (48) decrease in size from the gate (22, 26) towards the drain (20); and
wherein the two dimensional electron gas (44) increases in density in the drift region from the gate (22, 26) towards the drain (20); or
wherein the plurality of varying size openings (48) increase in size from the gate (22, 26) towards the drain (20).

3. The high electron mobility field effect transistor of claim 1 wherein:
the substrate (12) comprises silicon, sapphire, silicon carbide, OR bulk single crystal gallium nitride;
the channel layer (14) comprises a GaN layer; and the barrier layer (16) comprises a AlGaN layer.

4. The high electron mobility field effect transistor of claim 1 further comprising:
a passivation layer (24) over the stress inducing layer (46); and
wherein the gate (22, 26) comprises:
gate metal (22) extending through the passivation layer (24) and into the barrier layer; and
a gate dielectric layer (26) surrounding the gate metal (22) extending through the passivation layer (24) and into the barrier layer (16).

5. The high electron mobility field effect transistor of claim 1 further comprising:
a passivation layer (24) over the stress inducing layer (46); and wherein the gate (22, 26) comprises :
gate metal (22) extending through the passivation layer (24) and the barrier layer (16) and into the channel layer (14); and
a gate dielectric layer (26) surrounding the gate metal (22) extending through the passivation layer (24) and the barrier layer (16) and into the channel layer (14).

6. The high electron mobility field effect transistor of claim 1 further comprising:
an opening in the stress inducing layer (46) under the drain (20) for providing contact of the drain (20) to the barrier layer (16); and
an opening in the stress inducing layer (46) under a source (18) for providing contact of the source (18) to the barrier layer (16).

7. A method of fabricating a high electron mobility field effect transistor (10), the method comprising:
forming a channel layer (14) on a substrate (12); and
forming a barrier layer (16) on the channel layer (14); the method being **characterized in that** it comprises:
forming a stress inducing layer (46) on the barrier layer (16), the stress inducing layer (46) comprising a material having a plurality of varying size openings (48) in a drift region between a gate (22, 26) and a drain (20) such that the stress inducing layer (46) modulates the piezo-electric effect in the barrier layer (16) along the drift region;
such that a two dimensional electron gas (44) has a non-uniform lateral distribution in the drift region.

8. The method of claim 7 wherein:
the plurality of varying size openings (48) decrease in size from the gate (22, 26) towards the drain (20); and
the two dimensional electron gas increases in density in the drift region from the gate (22, 26) towards the drain (20); or
wherein the plurality of varying size openings (48) increase in size from the gate (22, 26) towards the drain (20).

9. The method of claim 7 further comprising:
forming a passivation layer (24) over the stress inducing layer (46); and
forming a gate (22, 26) comprising the steps of:
forming a trench extending through the passivation layer (24) and into the barrier layer (16); and
depositing a gate dielectric layer (26) in the trench; and
forming gate metal (22) on the gate dielectric layer (26).

10. The method of claim 9 wherein forming a trench extending through the passivation layer (24) and into the barrier layer (16) further comprises:
forming the trench to extend into the channel layer (14).

11. The method of claim 7, further comprising:
forming an opening in the stress inducing layer (46) under the drain (20) for providing contact of the drain (20) to the barrier layer (16); and
forming an opening in the stress inducing layer (46) under a source (18) for providing contact of the source (18) to the barrier layer (16).

## Patentansprüche

1. Feldeffekttransistor (10) mit hoher Elektronenmobilität mit einem Substrat (12), einer Kanalschicht (14) auf dem Substrat und einer Sperrschicht (16) auf der Kanalschicht (14), wobei der Feldeffekttransistor (10) mit hoher Elektronenmobilität **dadurch gekennzeichnet ist, dass** er folgendes umfasst:
eine stressinduzierende Schicht (46) auf der Sperrschicht (16), wobei die stressinduzierende Schicht (46) ein Material umfasst, das in einem Driftgebiet zwischen einem Gate-Anschluss (22, 26) und einem Drain-Anschluss (20) eine Mehrzahl von Öffnungen (48) mit unterschiedlicher Größe aufweist, so dass die stressinduzierende Schicht (46) den piezoelektrischen Effekt in der Sperrschicht (1 6) entlang des Driftbereichs moduliert;
so dass ein zweidimensionales Elektronengas (44) eine ungleichmäßige laterale Verteilung in dem Driftbereich aufweist.

2. Feldeffekttransistor (10) mit hoher Elektronenmobilität nach Anspruch 1:
wobei die Mehrzahl von Öffnungen (48) mit unterschiedlicher Größe von dem Gate-Anschluss (22, 26) zu dem Drain-Anschluss (20) in der Größe abnimmt; und
wobei die Dichte des zweidimensionalen Elektronengases (44) in dem Driftbereich von dem Gate-Anschluss (22, 26) zu dem Drain-Anschluss (20) zunimmt; oder
wobei die Mehrzahl von Öffnungen (48) mit unterschiedlicher Größe von dem Gate-Anschluss (22, 26) zu dem Drain-Anschluss (20) in der Größe zunimmt.

3. Feldeffekttransistor (10) mit hoher Elektronenmobilität nach Anspruch 1, wobei:
das Substrat (12) Silizium, Saphir, Siliziumcarbid oder Volumeneinkristallgalliumnitrid umfasst;
die Kanalschicht (14) eine GaN-Schicht umfasst; und die Sperrschicht (16) eine AIGaN-Schicht umfasst.

4. Feldeffekttransistor (10) mit hoher Elektronenmobilität nach Anspruch 1, wobei dieser ferner folgendes umfasst:
eine Passivierungsschicht (24) über der stressinduzierenden Schicht (46); und
wobei der Gate-Anschluss (22, 26) folgendes umfasst:
ein Gate-Metall (22), das sich durch die Passivierungsschicht (24) und in die Sperrschicht erstreckt; und
eine dielektrische Gate-Schicht (26), welche das Gate-Metall (22) umgibt, das sich durch die Passivierungsschicht (24) und in die Sperrschicht (16) erstreckt.

5. Feldeffekttransistor (10) mit hoher Elektronenmobilität nach Anspruch 1, wobei dieser ferner folgendes umfasst:
eine Passivierungsschicht (24) über der stressinduzierenden Schicht (46); und wobei der Gate-Anschluss (22, 26) folgendes umfasst:
ein Gate-Metall (22), das sich durch die Passivierungsschicht (24) und die Sperrschicht (16) und in die Kanalschicht (14) erstreckt; und
eine dielektrische Gate-Schicht (26), welche das Gate-Metall (22) umgibt, das sich durch die Passivierungsschicht (24), die Sperrschicht (16) und in die Kanalschicht (14) erstreckt.

6. Feldeffekttransistor (10) mit hoher Elektronenmobilität nach Anspruch 1, wobei dieser ferner folgendes umfasst:
eine Öffnung in der stressinduzierenden Schicht (46) unter dem Drain-Anschluss (20), um einen Kontakt des Drain-Anschlusses (20) mit der Sperrschicht (16) bereitzustellen; und
eine Öffnung in der stressinduzierenden Schicht (46) unter einem Source-Anschluss (18), um einen Kontakt des Source-Anschlusses (18) mit der Sperrschicht (16) bereitzustellen.

7. Verfahren zum Herstellen eines Feldeffekttransistors (10) mit hoher Elektronenmobilität, wobei das Verfahren folgendes umfasst:
Ausbilden einer Kanalschicht (14) auf einem Substrat (12); und
Ausbilden einer Sperrschicht (16) auf der Kanalschicht (14); wobei das Verfahren **dadurch gekennzeichnet ist, dass** es folgendes umfasst:
Ausbilden einer stressinduzierenden Schicht (46) auf der Sperrschicht (16), wobei die stressinduzierende Schicht (46) ein Material umfasst, das in einem Driftgebiet zwischen einem Gate-Anschluss (22, 26) und einem Drain-Anschluss (20) eine Mehrzahl von Öffnungen (48) mit unterschiedlicher Größe aufweist, so dass die stressinduzierende Schicht (46) den piezoelektrischen Effekt in der Sperrschicht (16) entlang des Driftbereichs moduliert;
so dass ein zweidimensionales Elektronengas (44) eine ungleichmäßige laterale Verteilung in dem Driftbereich aufweist.

8. Verfahren nach Anspruch 7, wobei:
wobei die Mehrzahl von Öffnungen (48) mit unterschiedlicher Größe von dem Gate-Anschluss (22, 26) zu dem Drain-Anschluss (20) in der Größe abnimmt; und
wobei die Dichte des zweidimensionalen Elektronengases in dem Driftbereich von dem Gate-Anschluss (22, 26) zu dem Drain-Anschluss (20) zunimmt; oder
wobei die Mehrzahl von Öffnungen (48) mit unterschiedlicher Größe von dem Gate-Anschluss (22, 26) zu dem Drain-Anschluss (20) in der Größe zunimmt.

9. Verfahren nach Anspruch 7, wobei das Verfahren ferner folgendes umfasst:
Ausbilden einer Passivierungsschicht (24) über der stressinduzierenden Schicht (46); und
Ausbilden eines Gate-Anschlusses (22, 26), wobei dies die folgenden Schritte umfasst:
Ausbilden eines Grabens, der sich durch die Passivierungsschicht (24) und in die Sperrschicht (16) erstreckt; und
Abscheiden einer dielektrischen Gate-Schicht (26) in dem Graben; und
Ausbilden von Gate-Metall (22) auf der dielektrischen Gate-Schicht (26).

10. Verfahren nach Anspruch 9, wobei das Ausbilden eines Grabens, der sich durch die Passivierungsschicht (24) und in die Sperrschicht (16) erstreckt, ferner folgendes umfasst:
Ausbilden des Grabens, so dass sich dieser in die Kanalschicht (14) erstreckt.

11. Verfahren nach Anspruch 7, wobei dieses ferner folgendes umfasst:
Ausbilden einer Öffnung in der stressinduzierenden Schicht (46) unter dem Drain-Anschluss (20), um einen Kontakt des Drain-Anschlusses (20) mit der Sperrschicht (16) bereitzustellen; und
Ausbilden einer Öffnung in der stressinduzierenden Schicht (46) unter einem Source-Anschluss (18), um einen Kontakt des Source-Anschlusses (18) mit der Sperrschicht (16) bereitzustellen.

## Revendications

1. Transistor à effet de champ à haute mobilité électronique (10) ayant un substrat (12), une couche de canal (14) sur le substrat et une couche barrière (16) sur la couche de canal (14), le transistor à effet de champ à haute mobilité électronique (10) étant **caractérisé en ce qu'**il comprend :
une couche inductrice de contraintes (46) sur la couche barrière (16), la couche inductrice de contraintes (46) comprenant un matériau ayant une pluralité d'ouvertures de taille variable (48) dans une région de dérive entre une grille (22, 26) et un drain (20) de sorte que la couche inductrice de contraintes (46) module l'effet piézoélectrique dans la couche barrière (16) le long de la région de dérive ;
de sorte qu'un gaz électronique bidimensionnel (44) ait une distribution latérale non uniforme dans la région de dérive.

2. Transistor à effet de champ à haute mobilité électronique (10) selon la revendication 1,
la pluralité d'ouvertures de taille variable (48) diminuant en taille de la grille (22, 26) vers le drain (20) ; et
le gaz électronique bidimensionnel (44) augmentant en densité dans la région de dérive de la grille (22, 26) vers le drain (20) ; ou
la pluralité d'ouvertures de taille variable (48) augmentant en taille de la grille (22, 26) vers le drain (20).

3. Transistor à effet de champ à haute mobilité électronique selon la revendication 1,
le substrat (12) comprenant du silicium, du saphir, du carbure de silicium ou du nitrure de gallium monocristallin en vrac ;
la couche de canal (14) comprenant une couche de GaN ; et la couche barrière (16) comprenant une couche d'AlGaN.

4. Transistor à effet de champ à haute mobilité électronique selon la revendication 1, comprenant en outre :
une couche de passivation (24) sur la couche inductrice de contraintes (46) ; et
la grille (22, 26) comprenant :
du métal de grille (22) s'étendant à travers la couche de passivation (24) et dans la couche barrière ; et
une couche diélectrique de grille (26) entourant le métal de grille (22) s'étendant à travers la couche de passivation (24) et dans la couche barrière (16).

5. Transistor à effet de champ à haute mobilité électronique selon la revendication 1, comprenant en outre :
une couche de passivation (24) sur la couche inductrice de contraintes (46) ; et la grille (22, 26) comprenant :
du métal de grille (22) s'étendant à travers la couche de passivation (24) et la couche barrière (16) et dans la couche de canal (14) ; et
une couche diélectrique de grille (26) entourant le métal de grille (22) s'étendant à travers la couche de passivation (24) et la couche barrière (16) et dans la couche canal (14).

6. Transistor à effet de champ à haute mobilité électronique selon la revendication 1, comprenant en outre :
une ouverture dans la couche inductrice de contraintes (46) sous le drain (20) pour assurer le contact du drain (20) avec la couche barrière (16) ; et
une ouverture dans la couche inductrice de contraintes (46) sous une source (18) pour fournir un contact de la source (18) avec la couche barrière (16).

7. Procédé de fabrication d'un transistor à effet de champ à haute mobilité électronique (10), le procédé comprenant les étapes consistant à :
former une couche de canal (14) sur un substrat (12) ; et
formant une couche barrière (16) sur la couche de canal (14) ; le procédé étant **caractérisé en ce qu'**il comprend l'étape consistant à :
former une couche inductrice de contraintes (46) sur la couche barrière (16), la couche inductrice de contraintes (46) comprenant un matériau ayant une pluralité d'ouvertures de taille variable (48) dans une région de dérive entre une grille (22, 26) et un drain (20) de sorte que la couche inductrice de contraintes (46) module l'effet piézoélectrique dans la couche barrière (16) le long de la région de dérive ;
de sorte qu'un gaz électronique bidimensionnel (44) ait une distribution latérale non uniforme dans la région de dérive.

8. Procédé selon la revendication 7,
la pluralité d'ouvertures de taille variable (48) diminuant en taille de la grille (22, 26) vers le drain (20) ; et
le gaz électronique bidimensionnel augmentant en densité dans la région de dérive de la grille (22, 26) vers le drain (20) ; ou
la pluralité d'ouvertures de taille variable (48) augmentant en taille de la grille (22, 26) vers le drain (20).

9. Procédé selon la revendication 7 comprenant en outre les étapes consistant à :
former une couche de passivation (24) sur la couche inductrice de contraintes (46) ; et
former une grille (22, 26) comprenant les étapes consistant à :
former une tranchée s'étendant à travers la couche de passivation (24) et dans la couche barrière (16) ; et
déposer une couche diélectrique de grille (26) dans la tranchée ; et
former un métal de grille (22) sur la couche diélectrique de grille (26).

10. Procédé selon la revendication 9, la formation d'une tranchée s'étendant à travers la couche de passivation (24) et dans la couche barrière (16) comprenant en outre l'étape consistant à :
former la tranchée pour s'étendre dans la couche de canal (14).

11. Procédé selon la revendication 7 comprenant en outre les étapes consistant à :
former une ouverture dans la couche inductrice de contraintes (46) sous le drain (20) pour assurer le contact du drain (20) avec la couche barrière (16) ; et
former une ouverture dans la couche inductrice de contraintes (46) sous une source (18) pour fournir un contact de la source (18) avec la couche barrière (16).
